# EUROPEAN PATENT SPECIFICATION

(11) **EP 3 852 135 B1**
(45) Date of publication and mention of the grant of the patent: **21.06.2023**
(21) Application number: 19859818.7
(22) Date of filing: 27.08.2019
(51) Int. Cl.: H01L 21/683, H01L 21/67, H01L 23/32

(54) **ELECTROSTATIC CHUCK**
ELEKTROSTATISCHES FUTTER
MANDRIN ÉLECTROSTATIQUE

(30) Priority: 14.09.2018 CN 201811073364
(43) Date of publication of application: 21.07.2021
(73) Proprietor: Beijing NAURA Microelectronics Equipment Co., Ltd., Beijing 100176 (CN)
(72) Inventor: LIU, Pengliang, Beijing 100176 (CN)
(74) Representative: Cohausz & Florack
(86) International application number: PCT/CN2019/102828
(87) International publication number: WO 2020/052432

(56) References cited:
- CN-A- 101 154 612
- CN-A- 101 512 750
- CN-A- 103 904 014
- CN-A- 103 904 014
- CN-A- 107 300 835
- JP-A- 2017 092 156
- US-A- 5 851 298
- US-A1- 2005 173 403
- US-A1- 2006 098 379
- US-A1- 2008 083 724
- US-A1- 2009 059 461
- US-A1- 2016 276 196
- US-A1- 2018 096 870

## Description

### TECHNICAL FIELD

The present disclosure relates to the field of semiconductor manufacturing, and in particular, to an electrostatic chuck.

### BACKGROUND

Electrostatic chucks (ESCs) are widely applied to the manufacturing processes of integrated circuits (ICs), especially to plasma etching (ETCH), physical vapor deposition (PVD), chemical vapor deposition (CVD), and the like. The ESC is used for fixing a wafer in a reaction chamber, and can be also used for applying direct current bias to a wafer, controlling wafer temperature, or the like.

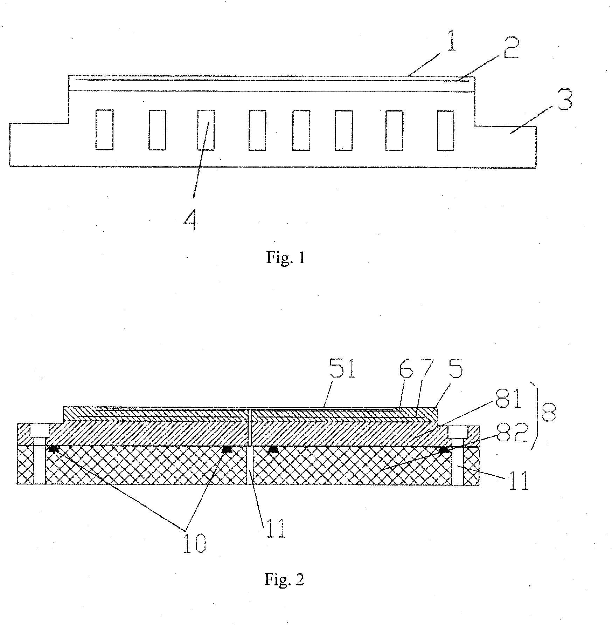

As shown in Fig. 1, an electrostatic chuck typically includes a heat insulating layer 1, a direct current electrode layer 2, and a base 3. At present, the heat insulating layer 1 is made of a ceramic material (Al₂O₃). The direct current electrode layer 2 is buried in the heat insulating layer 1 by a sintering or spraying process, and is configured to generate electrostatic attraction for a wafer, so as to fix the wafer. The base 3 is configured to support the heat insulating layer 1, and is provided therein with a channel 4 allowing a heat exchange medium to pass therethrough, so that the temperature of the wafer can be controlled by means of heat conduction.

However, the above electrostatic chuck can be used only within a certain temperature range (below 220°C), and will cause the following problems if used beyond the range:
firstly, the heat insulating layer 1 and the base 3 are bonded together with a silicon adhesive, but the silicon adhesive will fail at a high temperature (above 200°C) due to its characteristics, and thus cannot perform a vacuum sealing function, which finally disables the electrostatic chuck;
secondly, high-temperature circulating bath oil is generally used as the heat exchange medium at present and can reach a temperature as high as 220°C, and such a high temperature may lead to an over-high temperature (above 150°C) of the base 3, so that a lower electrode system disposed at and in contact with the bottom of the base 3 is damaged due to the unbearable over-high temperature; and
thirdly, for specific processes such as GaN etching, an etching condition of high temperature above 300°C should be met to facilitate repair to a GaN etching result and improvement in device performance. However, the above electrostatic chuck cannot reach such a high temperature, and thus cannot meet the requirements of some specific processes.

US 5851298 discloses a susceptor structure for mounting a semiconductor wafer.

### SUMMARY

The present disclosure aims to solve at least one of the technical problems in the existing art, and provides an electrostatic chuck, which has an increased highest temperature, achieves reliable vacuum sealing at a high temperature, and can be fit with a lower electrode structure.

To achieve the above objective of the present disclosure, there is provided an electrostatic chuck according to claim 1. Additional features are disclosed in the dependent claims.

The present disclosure has the following beneficial effects.

According to the electrostatic chuck provided by the present disclosure, by disposing the heating element inside the thermally conductive layer to transfer heat to the wafer through the thermally conductive layer, the highest temperature of the electrostatic chuck can be effectively increased (for example, above 300°C), thereby meeting the requirements of some specific processes; meanwhile, by disposing the heat insulating layer group below the thermally conductive layer to control the temperature of the bottom of the heat insulating layer group within a set range (for example, below 150°C), the lower electrode system can be prevented from being damaged due to high temperature, so that the electrostatic chuck and the lower electrode system can be fit together; moreover, by sealing the heat insulating layer group and the thermally conductive layer in an integrated manner (that is, connecting the heat insulating layer group with the thermally conductive layer to form an integral body), the vacuum sealing of the electrostatic chuck at a high temperature can be ensured, and the problem of seal failure due to high temperature can be avoided.

### BRIEF DESCRIPTION OF THE DRAWINGS

Fig. 1 is a structural diagram of a conventional electrostatic chuck; and
Fig. 2 is a cross-sectional view of an electrostatic chuck according to an embodiment of the present disclosure.

### DETAILED DESCRIPTIOIN

In order to enable those skilled in the art to better understand the technical solutions of the present disclosure, an electrostatic chuck provided by the present disclosure will be described in detail below with reference to the accompanying drawings.

With reference to Fig. 2, according to an embodiment of the present disclosure, an electrostatic chuck includes a thermally conductive layer 5 and a heat insulating layer group 8. The thermally conductive layer 5 includes a carrying surface for carrying a wafer. Optionally, a wafer recess 51 is formed in an upper surface of the thermally conductive layer 5 to define the position of the wafer on the thermally conductive layer 5, and a bottom surface of the wafer recess 51 is the carrying surface used for carrying the wafer. A heating element 7, such as a heating electrode, is disposed inside the thermally conductive layer 5, and can generate heat when being powered on, and the heat is transferred to the wafer through the thermally conductive layer 5. Thus, the highest temperature of the electrostatic chuck can be effectively increased (for example, above 300°C) to meet the requirements of some specific processes.

In the embodiment, the thermally conductive layer is further provided therein with a direct current electrode 6 configured to generate electrostatic attraction for the wafer, thereby fixing the wafer.

Optionally, a lower electrode system disposed at the bottom of the electrostatic chuck may be configured to apply radio frequency bias to the wafer. Specifically, the lower electrode system includes a base for carrying an electrostatic chuck, and the radio frequency power is applied to the base to introduce the radio frequency energy. However, the present disclosure is not limited thereto. In practical applications, a radio frequency electrode, which is used for simultaneous applying of a radio frequency voltage and a direct current voltage, may be disposed inside the thermally conductive layer 5 to replace the direct current electrode 6. By simultaneously applying a radio frequency voltage and a direct current voltage to the radio frequency electrode, the electrostatic attraction and the introduction of radio frequency energy can be simultaneously achieved. In this way, the structure of the lower electrode system can be simplified. Moreover, by disposing a radio frequency electrode layer inside the thermally conductive layer 5 by sintering, a partial pressure to the wafer in a direction perpendicular to the wafer can be increased, so that the capability of plasma to bombard the wafer can be enhanced, thereby improving etching efficiency.

Optionally, a distance between an upper surface of the direct current electrode 6 (or the radio frequency electrode) and the carrying surface of the thermally conductive layer 5 used for carrying the wafer is 1.5mm. Such distance can ensure that the wafer is firmly fixed on the thermally conductive layer 5 by the electrostatic attraction generated between the direct current electrode 6 and the wafer.

Optionally, the radio frequency electrode is made into a mesh structure, so as to evenly introduce radio frequency energy to improve process uniformity.

Optionally, the direct current electrode 6 is made of a conductive material such as Mo. A thickness of the direct current electrode 6 ranges from 0.2mm to 0.4mm.

Optionally, the heating element 7 is made of a conductive material such as Mo. A thickness of the heating electrode 7 ranges from 0.1mm to 0.3mm.

Optionally, the heating element 7 is a heating electrode, and a distance between an upper surface of the heating electrode and the carrying surface of the thermally conductive layer 5 used for carrying the wafer is 3mm. Such distance can guarantee heating efficiency.

Optionally, the heating electrode is made into a sheet structure, and the sheet structure facilitates improving thermal conductivity, thereby increasing heating efficiency. Optionally, a thickness of the heating electrode ranges from 0.1mm to 0.3mm. Such thickness range is beneficial to the improvement in the thermal conductivity, so that a temperature ranging from 320°C to 330°C can be reached.

The heat insulating layer group 8 is disposed below the thermally conductive layer 5 to control a temperature of the bottom of the heat insulating layer group 8 within a set range; moreover, the heat insulating layer group 8 and the thermally conductive layer 5 are sealed in an integrated manner (that is, being connected into an integral body) by sintering. By disposing the heat insulating layer group 8 below the thermally conductive layer 5 to control the temperature of the bottom of the heat insulating layer group 8 within a set range (for example, below 150°C), the lower electrode system can be prevented from being damaged due to high temperature, so that the electrostatic chuck and the lower electrode system can be fit together. In addition, by connecting the heat insulating layer group 8 with the thermally conductive layer 5 to form an integral body to realize the sealing thereof, vacuum sealing of the electrostatic chuck at a high temperature can be ensured, and the limitation at a high temperature caused by a sealing structure such as an adhesive and a sealing ring can be avoided, so that the electrostatic chuck can work at a high temperature (above 300°C); meanwhile, the problem of seal failure, which is caused by different thermal expansion degrees of the heat insulating layer group 8 and the thermally conductive layer 5, can be completely solved.

Specifically, the heat insulating layer group 8 includes at least two heat insulating layers, which are sequentially arranged from top to bottom in descending order of thermal conductivity coefficient. Thus, the temperatures of the heat insulating layers can gradually decrease from top to bottom, so that a temperature of the bottom of the lowermost heat insulating layer can be controlled within a set range (for example, below 150°C). Moreover, the uppermost heat insulating layer and the thermally conductive layer 5 are sealed by being connected into an integral body, so that the vacuum sealing of the electrostatic chuck at a high temperature can be ensured. A method of connecting into an integral body is sintering.

In the embodiment, two heat insulating layers are provided, and include an upper first heat insulating layer 81 and a lower second heat insulating layer 82. In practical applications, the heat insulating layers may be designed as required, such as a single heat insulating layer, or three, four or more heat insulating layers with gradually changing thermal conductivity coefficient.

It is easy to understand that the thermal conductivity coefficients of all the heat insulating layers must be less than the thermal conductivity coefficient of the thermally conductive layer 5 for ensuring heat insulation. Optionally, the thermal conductivity coefficient of the thermally conductive layer 5 ranges from 130w/(m·k) to 170w/(m-k); and the thermal conductivity coefficient of the first heat insulating layer 81 ranges from 70w/(m·k) to 90w/(m·k). Those ranges can guarantee an effective heat insulation effect, so that the temperature of the first heat insulating layer 81 is decreased relative to the temperature of the thermally conductive layer 5.

A material of the thermally conductive layer 5 includes aluminum nitride (AIN). Aluminum nitride is a covalent compound, an insulator, and an atomic crystal, and belongs to a diamond nitride. A thermal conductivity coefficient of a polycrystalline material of the diamond nitride ranges from 70w/(m·k) to 210w/(m·k), and a thermal conductivity coefficient of a single crystal of the diamond nitride can be as high as 275w/(m·k). Therefore, aluminum nitride has good heat transfer capacity. With the thermally conductive layer 5 made of aluminum nitride, the highest temperature of the electrostatic chuck can be effectively increased (for example, above 300°C), thereby meeting the requirements of some specific processes.

In the embodiment, a material of the thermally conductive layer 5 and a material of the first heat insulating layer 81 both include aluminum nitride; and the thermally conductive layer 5 and/or the first heat insulating layer 81 are/is doped with at least one trace element in a predetermined proportion, so that the thermal conductivity coefficient of the first heat insulating layer 81 is less than that of the thermally conductive layer 5. Optionally, the thermal conductivity coefficient of the thermally conductive layer 5 is 140w/(m-k); and the thermal conductivity coefficient of the first heat insulating layer 81 is 70w/(m·k).

The second heat insulating layer 82 is disposed under the first heat insulating layer 81, and has a thermal conductivity coefficient less than that of the first heat insulating layer 81. In this way, the temperature of the second heat insulating layer 82 is further decreased relative to the temperature of the first heat insulating layer 81, for example, the temperature of the bottom of the second heat insulating layer 82 is below 150°C. By controlling the temperature of the bottom of the second heat insulating layer 82 below 150°C, the lower electrode system can be effectively prevented from being damaged due to high temperature, so that the electrostatic chuck and the lower electrode system can be fit together.

Optionally, the thermal conductivity coefficient of the second heat insulating layer 82 is 1.5w/(m·k), which may make the temperature of the bottom of the second heat insulating layer 82 below 150°C. Preferably, a material of the second heat insulating layer 82 includes quartz.

Optionally, two adjacent heat insulating layers are fixedly connected by a fastener, and are sealed together by a perfluorinated sealing ring. For example, in the embodiment, the first heat insulating layer 81 and the second heat insulating layer 82 are fixedly connected by fasteners 11, and sealing rings 10 are provided between the first heat insulating layer 81 and the second heat insulating layer 82 to seal a gap therebetween and seal a center hole 11. Optionally, the sealing rings 10 are high-temperature-resistant sealing rings, such as perfluorinated sealing rings. The center hole 11 is configured to lead out the wires of the direct current electrode 6 and the heating electrode 7.

In summary, as for the electrostatic chuck provided by the present disclosure, by disposing the heating element inside the thermally conductive layer to transfer heat to the wafer through the thermally conductive layer, the highest temperature of the electrostatic chuck can be effectively increased (for example, above 300°C), thereby meeting the requirements of some specific processes; meanwhile, by disposing the heat insulating layer group below the thermally conductive layer to control the temperature of the bottom of the heat insulating layer group within a set range (for example, below 150°C), the lower electrode system can be prevented from being damaged due to high temperature, so that the electrostatic chuck and the lower electrode system can be fit together; moreover, by connecting the heat insulating layer group with the thermally conductive layer to form an integral body to realize the sealing thereof, the vacuum sealing of the electrostatic chuck at a high temperature can be ensured, and the problem of seal failure due to high temperature can be avoided.

It should be understood that the above embodiments are merely exemplary embodiments adopted to illustrate the principles of the present disclosure, and the present disclosure is not limited thereto.

The invention is defined by the appended claims.

## Claims

1. An electrostatic chuck, comprising:
a thermally conductive layer (5) configured to carry a wafer and provided therein with a heating element (7); and
a heat insulating layer group (8) disposed below the thermally conductive layer and configured to control a temperature of a bottom of the heat insulating layer group within a set range; and
the heat insulating layer group comprises at least two heat insulating layers (81,82), which are sequentially arranged from top to bottom in descending order of thermal conductivity coefficient;
both a material of the thermally conductive layer and a material of an uppermost heat insulating layer (81) of the at least two heat insulating layers comprise aluminum nitride, and the thermally conductive layer and the uppermost heat insulating layer are connected into an integral body by sintering; at least one of the thermally conductive layer and the uppermost heat insulating layer is doped with at least one trace element in a predetermined proportion, so that a thermal conductivity coefficient of the uppermost heat insulating layer is less than a thermal conductivity coefficient of the thermally conductive layer; and a material of a lowermost heat insulating layer (82) of the at least two heat insulating layers comprises quartz.

2. The electrostatic chuck of claim 1, wherein the thermal conductivity coefficient of the thermally conductive layer ranges from 130W/(m·K) to 170 W/(m·K); and thethermal conductivity coefficient of the uppermost heat insulating layer ranges from 70 W/(m·K) to 90 W/(m·K).

3. The electrostatic chuck of claim 2, wherein the thermal conductivity coefficient of the uppermost heat insulating layer is 70 W/(m·K), and the thermal conductivity coefficient of the thermally conductive layer is 140 W/(m·K).

4. The electrostatic chuck of claim 2 or 3, wherein the heat insulating layer group comprises two heat insulating layers, and a thermal conductivity coefficient of a lower heat insulating layer of the two heat insulating layers is 1.5 W/(m·K).

5. The electrostatic chuck of claim 1, wherein two adjacent heat insulating layers of the at least two heat insulating layers are fixedly connected by a fastener (11), and are sealed together by a perfluorinated sealing ring (10) therebetween.

6. The electrostatic chuck of claim 1, wherein the thermally conductive layer is further provided therein with a direct current electrode (6) configured to generate electrostatic attraction for a wafer, and a distance between an upper surface of the direct current electrode and a carrying surface of the thermally conductive layer is 1.5mm.

7. The electrostatic chuck of claim 1, wherein the thermally conductive layer is further provided therein with a radio frequency electrode used for simultaneous applying of a radio frequency voltage and a direct current voltage, and a distance between an upper surface of the radio frequency electrode and a carrying surface of the thermally conductive layer is 1.5mm.

8. The electrostatic chuck of claim 7, wherein the radio frequency electrode is made into a mesh structure; and a thickness of the radio frequency electrode ranges from 0.2mm to 0.4mm.

9. The electrostatic chuck of claim 6 or 7, wherein the heating element is a heating electrode, and a distance between an upper surface of the heating electrode and the carrying surface of the thermally conductive layer is 3mm.

10. The electrostatic chuck of claim 9, wherein the heating electrode is made into a sheet structure; and a thickness of the heating electrode ranges from 0.1mm to 0.3mm.

## Patentansprüche

1. Elektrostatische Spannvorrichtung, aufweisend:
eine wärmeleitende Schicht (5), die konfiguriert ist, um einen Wafer zu tragen und darin mit einem Heizelement (7) versehen ist; und
eine wärmeisolierende Schichtgruppe (8), die unter der wärmeleitenden Schicht angeordnet und konfiguriert ist, um eine Temperatur eines Bodens der wärmeisolierenden Schichtgruppe innerhalb eines festgelegten Bereichs zu steuern; und
wobei die wärmeisolierende Schichtgruppe mindestens zwei wärmeisolierende Schichten (81, 82) aufweist, die in absteigender Reihenfolge des Wärmeleitfähigkeitskoeffizienten sequentiell von oben nach unten angeordnet sind; sowohl ein Material der wärmeleitenden Schicht als auch ein Material einer obersten wärmeisolierenden Schicht (81) der mindestens zwei wärmeisolierenden Schichten Aluminiumnitrid umfassen, und die wärmeleitende Schicht und die oberste wärmeisolierende Schicht durch Sintern zu einem integralen Körper verbunden sind; mindestens eine von der wärmeleitenden Schicht und der obersten wärmeisolierenden Schicht mit mindestens einem Spurenelement in einem vorbestimmten Anteil dotiert ist, so dass ein Wärmeleitfähigkeitskoeffizient der obersten wärmeisolierenden Schicht kleiner als ein Wärmeleitfähigkeitskoeffizient der wärmeleitenden Schicht ist; und ein Material einer untersten wärmeisolierenden Schicht (82) der mindestens zwei wärmeisolierenden Schichten Quarz umfasst.

2. Elektrostatische Spannvorrichtung nach Anspruch 1, wobei der Wärmeleitfähigkeitskoeffizient der wärmeleitenden Schicht im Bereich von 130 W/(m·K) bis 170 W/(m·K) liegt; und der Wärmeleitfähigkeitskoeffizient der obersten wärmeisolierenden Schicht im Bereich von 70 W/(m·K) bis 90 W/(m·K) liegt.

3. Elektrostatische Spannvorrichtung nach Anspruch 2, wobei der Wärmeleitfähigkeitskoeffizient der obersten wärmeisolierenden Schicht 70 W/(m·K) beträgt und der Wärmeleitfähigkeitskoeffizient der wärmeleitenden Schicht 140 W/(m·K) beträgt.

4. Elektrostatische Spannvorrichtung nach Anspruch 2 oder 3, wobei die wärmeisolierende Schichtgruppe zwei wärmeisolierende Schichten aufweist und der Wärmeleitfähigkeitskoeffizient einer unteren wärmeisolierenden Schicht der zwei wärmeisolierenden Schichten 1,5 W/(m·K) beträgt.

5. Elektrostatische Spannvorrichtung nach Anspruch 1, wobei zwei benachbarte wärmeisolierende Schichten der mindestens zwei wärmeisolierenden Schichten durch ein Befestigungselement (11) fest verbunden sind und durch einen dazwischenliegenden perfluorierten Dichtungsring (10) miteinander versiegelt sind.

6. Elektrostatische Spannvorrichtung nach Anspruch 1, wobei die wärmeleitende Schicht ferner mit einer Gleichstromelektrode (6) versehen ist, die konfiguriert ist, um eine elektrostatische Anziehung für einen Wafer zu erzeugen, und ein Abstand zwischen einer oberen Fläche der Gleichstromelektrode und einer tragenden Fläche der wärmeleitenden Schicht 1,5 mm beträgt.

7. Elektrostatische Spannvorrichtung nach Anspruch 1, wobei die wärmeleitende Schicht ferner mit einer Hochfrequenzelektrode versehen ist, die zum gleichzeitigen Anlegen einer Hochfrequenzspannung und einer Gleichstromspannung verwendet wird, und ein Abstand zwischen einer oberen Fläche der Hochfrequenzelektrode und einer tragenden Fläche der wärmeleitenden Schicht 1,5 mm beträgt.

8. Elektrostatische Spannvorrichtung nach Anspruch 7, wobei die Hochfrequenzelektrode in einer Gitterstruktur hergestellt ist und die Dicke der Hochfrequenzelektrode im Bereich von 0,2 mm bis 0,4 mm liegt.

9. Elektrostatische Spannvorrichtung nach Anspruch 6 oder 7, wobei das Heizelement eine Heizelektrode ist und ein Abstand zwischen einer oberen Fläche der Heizelektrode und der tragenden Fläche der wärmeleitenden Schicht 3 mm beträgt.

10. Elektrostatische Spannvorrichtung nach Anspruch 9, wobei die Heizelektrode in einer Blechstruktur hergestellt ist und eine Dicke der Heizelektrode im Bereich von 0,1 mm bis 0,3 mm liegt.

## Revendications

1. Un socle électrostatique, comprenant :
une couche (5) thermiquement conductrice configurée pour porter une plaquette et munie en elle d'un élément chauffant (7) ; et
un groupe (8) de couches thermiquement isolantes disposé sous la couche thermiquement conductrice et configuré pour réguler une température d'un fond du groupe de couches thermiquement isolantes dans une gamme définie ; et
le groupe de couches thermiquement isolantes comprend au moins deux couches thermiquement isolantes (81, 82), qui sont agencées séquentiellement de haut en bas dans un ordre décroissant du coefficient de conductivité thermique ; un matériau de la couche thermiquement conductrice et un matériau d'une couche thermiquement isolante (81) située le plus sur le dessus desdites au moins deux couches thermiquement isolantes comprennent, tant l'un que l'autre, du nitrure d'aluminium, et la couche thermiquement conductrice et la couche thermiquement isolante située le plus sur le dessus sont reliées par frittage en un corps d'un seul tenant ; au moins une parmi la couche thermiquement conductrice et la couche thermiquement isolante la plus sur le dessus est dopée avec au moins un élément trace dans une proportion prédéterminée, de sorte qu'un coefficient de conductivité thermique de la couche thermiquement isolante la plus sur le dessus est inférieur à un coefficient de conductivité thermique de la couche thermiquement conductrice ; et un matériau d'une couche thermiquement isolante située la plus en-dessous (82) desdites au moins deux couches thermiquement isolantes comprend du quartz.

2. Le socle électrostatique selon la revendication 1, dans lequel le coefficient de conductivité thermique de la couche thermiquement conductrice est compris entre 130 W/(m·K) et 170 W/(m K) ; et le coefficient de conductivité thermique de la couche thermiquement isolante la plus sur le dessus est compris entre 70 W/(m·K) et 90 W/(m·K).

3. Le socle électrostatique selon la revendication 2, dans lequel le coefficient de conductivité thermique de la couche thermiquement isolante la plus sur le dessus est de 70 W/(m·K) et le coefficient de conductivité thermique de la couche thermiquement conductrice est de 140 W/(m·K).

4. Le socle électrostatique selon la revendication 2 ou la revendication 3, dans lequel le groupe de couches thermiquement isolantes comprend deux couches thermiquement isolantes, et un coefficient de conductivité thermique d'une couche thermiquement isolante inférieure des deux couches thermiquement isolantes est de 1,5 W/(m·K).

5. Le socle électrostatique selon la revendication 1, dans lequel deux couches thermiquement isolantes adjacentes desdites au moins deux couches thermiquement isolantes sont reliées de manière fixe par un organe de fixation (11) et sont reliées de manière étanche l'une à l'autre par une bague d'étanchéité perfluorée (10) entre elles.

6. Le socle électrostatique selon la revendication 1, dans lequel la couche thermiquement conductrice est en outre dotée d'une électrode à courant continu (6) configurée pour générer une attraction électrostatique pour une plaquette, et une distance entre une surface supérieure de l'électrode à courant continu et une surface de support de la couche thermiquement conductrice est de 1,5 mm.

7. Le socle électrostatique selon la revendication 1, dans lequel la couche thermiquement conductrice est en outre dotée d'une électrode radiofréquence utilisée pour l'application simultanée d'une tension radiofréquence et d'une tension de courant continu, et une distance entre une surface supérieure de l'électrode radiofréquence et une surface de support de la couche thermiquement conductrice est de 1,5 mm.

8. Le socle électrostatique selon la revendication 7, dans lequel l'électrode radiofréquence est réalisée selon une structure maillée ; et une épaisseur de l'électrode radiofréquence est comprise entre 0,2 mm et 0,4 mm.

9. Le socle électrostatique selon la revendication 6 ou la revendication 7, dans lequel l'élément chauffant est une électrode chauffante, et une distance entre une surface supérieure de l'électrode chauffante et la surface de support de la couche thermiquement conductrice est de 3 mm.

10. Le socle électrostatique selon la revendication 9, dans lequel l'électrode chauffante est réalisée en une structure en feuille ; et
une épaisseur de l'électrode chauffante est comprise entre 0,1 mm et 0,3 mm.
